(19) Europäisches Patentamt

European Patent Office

Office européen des brevets

(11) Publication number: **0 160 395 B1**

(12) **EUROPEAN PATENT SPECIFICATION**

(45) Date of publication of patent specification: **27.12.91**

(21) Application number: **85302163.2**

(22) Date of filing: **28.03.85**

(51) Int. Cl.⁵: **B41M 5/26, G03F 1/00, B41C 1/10**

(54) **Laser, imageable assembly and process for production thereof.**

(30) Priority: **25.04.84 GB 8410514**

(43) Date of publication of application:
**06.11.85 Bulletin 85/45**

(45) Publication of the grant of the patent:
**27.12.91 Bulletin 91/52**

(84) Designated Contracting States:
**DE FR GB IT**

(56) References cited:
**EP-A- 0 001 138      FR-A- 1 411 292**
**FR-A- 2 258 265      GB-A- 1 195 842**
**GB-A- 1 284 266      US-A- 3 149 563**
**US-A- 3 962 513      US-A- 4 157 412**
**US-A- 4 374 691      US-A- 4 439 485**

**PATENT ABSTRACTS OF JAPAN, vol. 6, no. 163 (M-152)[1041], 26th August 1982; JP-A-57 077 590 (KONISHIROKU SHASHIN KOGYO K.K.) 14-05-1982**

**IBM TECHNICAL DISCLOSURE BULLETIN, vol. 7, no. 3, August 1964, page 224, New York, US; D.D. ROSHON et al.: "Printing by means of a laser beam"**

(73) Proprietor: **IMPERIAL CHEMICAL INDUSTRIES PLC**
**Imperial Chemical House, Millbank**
**London SW1P 3JF(GB)**

(72) Inventor: **Butters, Alan**
**11 Bushey Close Capel St Mary**
**Ipswich Suffolk(GB)**
Inventor: **Barker, Roger Nicholson**
**Rowan Lodge Pilcox Hall Lane**
**Tendring Clacton-on-Sea Essex(GB)**
Inventor: **Rennison, Stuart Christopher**
**44 Annbeaumont Way Hadleigh**
**Nr Ipswich Suffolk(GB)**

(74) Representative: **Rhind, John Lessels et al**
**Imperial Chemical Industries PLC Legal Department: Patents PO Box No 6 Bessemer Road**
**Welwyn Garden City Herts AL7 1HD(GB)**

## Description

This invention relates to a laser-imageable assembly, to a method for the production thereof, and to a method for the production of a printing plate therefrom.

Laser-imageable assemblies are known in the art and generally comprise a transparent film substrate having on a surface thereof an energy absorbent transfer layer. Exposure of such an assembly to a laser beam directed through the transparent substrate, and focused at the interface between the substrate and transfer layer, results in the laser-struck portions of the transfer layer being displaced from the substrate to create a relatively clear pattern thereon.

If the exposure is conducted with the transfer layer of the assembly in intimate contact with the surface of a printing plate former, such as a grained, anodised aluminium plate, the displaced portions of the transfer layer adhere to the printing plate former and constitute an image pattern thereon. The residual exposed assembly constitutes a negative transparent master of the image produced by the laser beam and may be used for imaging photopolymer printing plates.

Generally, the transfer layer comprises a cross-linkable polymeric binder, whereby the image pattern transferred to a printing plate former may be rendered durable, for example - by heating to effect cross-linking of the transferred pattern

An acceptable laser-imageable assembly must satisfy several apparently conflicting criteria. Thus, the bond between the film substrate and transfer layer should be sufficiently strong to prevent accidental displacement of the transfer layer during handling of the assembly, and the material of the transfer layer must be durable and compatible with the receptive surface of a printing plate former. At the same time, the transfer layer must be readily separated from the film substrate to facilitate production of a negative transparent master with a clear imaged pattern.

US Patent No 4 157 412 discloses a composite material for forming graphics such as letters or numbers. The composite material includes a layer of latent adhesive material, a mono-layer of granules lightly adhered to a donor web, and a thin layer of bonding material between and in face-to-face contact with the layers of granules and adhesive. The layer of bonding material maintains the adhesive and granular layers in close proximity and excludes air from therebetween. When the composite material is selectively heated in graphic patterns, corresponding portions of the bonding layer melt; and corresponding portions of the adhesive material and granular layer soften, absorb the melted portions of the bonding layer and adhere together. Upon subsequent separation of the layer of adhesive and the donor web the remaining portions of the layer of bonding material separate, whereas granules transfer to the accepting tape in the heated areas to provide the graphics.

Preferably the granules are a mono-layer of granules (ie a layer of granules only one granule thick) of about 0.08 millimeter (0.003 inch) or less in diameter which can adhere to the layer of adhesive via surface contact without the need for the adhesive to flow into the interstices between the granules. These granules are comprised of a thermoplastic resin coated on a backing and dried by a novel method which promotes the formation of very small plate-like granules of the resin releasably adhered to the backing and adhered together at their margins by portions of the resin recessed from the exposed surface of the granules, Generally, that method comprises (1) dissolving the thermoplastic resin in a solvent mixture in which the resin is completely soluble, the mixture comprising a first highly volatile solvent and a second significantly less volatile solvent in which second solvent alone the resin is only partially soluble; (2) evenly coating the dissolved resin on a backing layer; (3) heating the coated backing layer at a first temperature adapted to evaporate the first highly volatile solvent at a much faster rate than the second solvent and cause the mixture to become mostly the second solvent so that the resin semi-solidifies in a mono-layer of localized granular-like areas; and then (4) evaporating the remaining solvent mixture to solidify the semi-solidified areas and provide the granular coating.

US Patent No 3 964 389 discloses a method of making an imaged printing plate using a transparent substrate coated with (a) particles which absorb laser energy, (b) a self-oxidizing binder, and (c) a cross-linking agent or a cross-linking agent in combination with a cross-linkable resin. Carbon black particles are dispersed in the coating to absorb laser energy. However, although the coating can be transferred to a lithographic printing surface by exposure to a laser beam of acceptable power, a residue of the coating layer tends to remain on the exposed area of the substrate rendering the latter unsuitable for use as a negative master. An undesirable increase in laser power is required to effect adequate removal of coating layer from the exposed area.

US Patent No 4 245 003 has therefore proposed the use of a laser-imageable member comprising a transparent film having thereon a dried, uniform coating comprising graphite particles and a non-self-oxidising binder in sufficient quantity to prevent removal of the coating under normal handling conditions.

2

However, such members have been observed to suffer partial detachment of the coating layer when placed in repeated contact with a dry photopolymer plate under vacuum and then separated.

We have now devised an improved assembly which eliminates or substantially overcomes these defects.

Accordingly, the present invention provides a laser-imageable assembly comprising a transparent substrate having on a surface thereof an energy absorbent transfer layer comprising particles which absorb laser energy dispersed in a resin layer wherein the resin layer is a heterogeneous, discontinuous layer, the surface thereof remote from the substrate being cracked or crazed, said surface exhibiting a Gardner Gloss (45°) of less than 50% and the thickness of the resin layer being from 0.5 to 5.0μm.

The invention further provides a method of making a laser-imageable assembly comprising:

(a) applying to a surface of a transparent substrate a coating medium comprising laser energy absorbent particles and a resin binder dispersed in a volatile vehicle, and

(b) drying the applied coating medium, wherein the drying is effected

(1) at a sufficiently low temperature, and optionally,

(2) in the presence of a non-solvent for the resin binder, to develop on the substrate a resin transfer layer, said resin layer being a heterogeneous, discontinuous layer, the surface thereof remote from the substrate being cracked or crazed, said surface exhibiting a Gardner Gloss (45°) of less than 50% and the thickness of the resin layer being from 0.5 to 5.0 μm.

By a heterogeneous resin layer is meant a resin layer of non-uniform composition with respect to the resin. In effect, the resin transfer layer is discontinuous and the discontinuities therein may manifest themselves as cracks or crazing in the outermost surface (remote from the substrate) of the resin layer, or as gaps between discrete particles or agglomerates of the resin. Alternatively, the resin layer may comprise an open-cell, voided structure.

The heterogeneous transfer layer is generally of a blushed or matt appearance, and the light scattering characteristics thereof provide a convenient means of assessing the degree of heterogeneity. The heterogeneous transfer layer exhibits a Gardner Gloss (45°) of less than about 50%, and preferably less than about 10%.

Binder resins suitable for use in forming the transfer layer include self-oxidising binders, such as nitrocellulose, and non-self-oxidising binders, such as ethylcellulose and polyacrylic acid (especially the alkali metal salts thereof, e.g. sodium or potassium salts). Desirably, the selected binder resin, when dried to form the transfer layer, should be insoluble in hydroxyethylmethacrylate to facilitate the use of the transfer assembly in the production of dry photopolymer printing plates.

The resin binder is desirably applied to the substrate as a dispersion or solution in a volatile vehicle, as hereinafter described, in an amount which will yield a dry transfer layer having a thickness of from 0.5 to 5 microns, particularly from 1 to 3 microns. The optical density, i.e. $\log_{10}(li/lt)$, where li is the intensity of the incident light, and It is the intensity of the transmitted light, of the resultant laser-imageable assembly is typically from about 2.0 to 3.5, particularly from 2.5 to 3.0, density units, as measured by a McBeth Densitometer (Model TD 528) using a Wratten 18A filter.

Energy absorbing particles suitable for inclusion in the transfer layer include any material, such as a pigment, having a broad absorption band embracing the visible and ultra violet spectrum, and in particular carbon black and graphite, the latter being preferred. Such particles suitably have a mean diameter of from 1 to 15 microns, preferably from 3 to 7 microns.

Energy absorbing particles are conveniently employed in the binder resin in an amount such that the weight ratio of particles to binder resin is from 10:1 to 1:2, preferably from 5:1 to 2:1.

The resin transfer layer may be applied to a surface of the substrate by conventional coating techniques. For example, a suspension of the energy absorbing particles in resin binder diluted to an appropriate viscosity in a volatile vehicle, such as an organic diluent, may be deposited on the substrate and spread thereon by a Meier bar, or applied by a roller coating technique. Suitable organic diluents include iso-propanol, ethanol or methyl ethyl ketone, and mixtures thereof - for example a mixture of methylethylketone and ethanol (3:1v/v). Drying of the applied resin coating is effected in conventional drying equipment, such as an air oven. Drying should be effected at a sufficiently low temperature, for example less than 70°C and preferably from 60 to 40°C, generally at about or below 50°C, to develop the desired heterogeneous structure in the transfer layer.

Development of the desired heterogeneous structure is assisted by effecting the drying in the presence of a non-solvent for the resin binder component. Desirably, the non-solvent is a material of relatively high boiling point, particularly one of higher boiling point than the volatile vehicle. Water is a particularly suitable non-solvent.

A relatively small amount of the non-solvent, for example - not exceeding 10% and conveniently less than 5% by volume of the applied coating medium (resin plus diluent) achieves the desired effect. For example, 60mls of water may be blended with 4 litres of coating medium, i.e. 1.5% v/v, prior to deposition of the coating medium onto the substrate.

Durability of an assembly according to the invention, particularly with respect to chemical resistance of the transfer layer may be improved, if desired, by inclusion in the transfer layer of a cross-linking agent for the binder resin, optionally in the presence of an additional cross-linkable polymeric resin. Cross-linking of the transfer layer may be effected by conventional techniques - for example, by heating the applied transfer coating during the aforementioned drying operation.

The substrate on which the transfer layer is deposited may comprise any suitable polymeric material particularly in the form of a self supporting transparent film or sheet. Suitable polymeric materials include cellulose esters, e.g. cellulose acetate, polystyrene, polyamides, polymers and copolymers of vinyl chloride, polymers and copolymers of olefines, e.g. polypropylene, polysulphones, polycarbonates and particularly linear polyesters which may be obtained by condensing one or more dicarboxylic acids or their lower alkyl diesters, e.g. terephthalic acid, isophthalic acid, phthalic acid, 2-5, 2,6- and 2,7- naphthalene dicarboxylic acid, succinic acid, sebacic acid, adipic acid, azelaic acid, diphenyl dicarboxylic acid and hexahydroterephthalic acid or bis-p-carboxyl phenoxy ethane, optionally with a mono-carboxylic acid, such as pivalic acid, with one or more glycols, e.g. ethylene glycol 1,3-propanediol, 1,4-butanediol, neopentyl glycol and 1,4-cyclohexane-dimethanol. A biaxially oriented and heat-set film of polyethylene terephthalate is particularly useful for the production of an assembly according to the invention and may be produced by any of the processes known in the art, e.g. as described in British patent specification 838 708.

The polymer substrate is suitably of a thickness from 25 to 250, particularly from 50 to 175 and especially about 75 microns.

Performance of an assembly according to the invention may be improved, if desired, by the inclusion of an intermediate priming layer between the substrate and transfer layer. Creation of a priming layer is conveniently effected by treating the surface of the polymer substrate with an agent known in the art to have a solvent or swelling action on the substrate polymer. Examples of such agents, which are particularly suitable for the treatment of a polyester substrate, include a halogenated phenol dissolved in a common organic solvent e.g. a solution of p-chloro-m-cresol, 2,4-dichlorophenol, 2,4,5,-or 2,4,6-trichlorophenol or 4-chlororesorcinol in acetone or methanol. In addition, and preferably, the priming solution may contain a partially hydrolysed vinyl chloride/vinyl acetate copolymer. Such a copolymer conveniently contains from 60 to 98 per cent of vinyl chloride, and from 0.5 to 3% of hydroxyl units, by weight of the copolymer. The molecular weight (number average) of the copolymer is conveniently in a range of from 10,000 to 30,000, and preferably from 16,500 to 25,000.

The priming agent is suitably applied at a concentration level which will yield a priming layer having a relatively thin dry coat thickness - for example, generally less than 2 microns, and preferably, less than 1 micron.

If desired, a protective medium such as a small amount of an incompatible polymer, may be deposited on the applied transfer layer to prevent or reduce coalescence thereof, thereby to enhance the durability and chemical resistance of the polymer layer. A suitable protective medium comprises a hydrophilic polymer, such as the condensation product of formaldehyde with the sodium salt of naphthalene sulphonic acid, and may be deposited from solution or dispersion in a suitable volatile medium, which is subsequently removed by drying, to form a hydrophilic protective coating on the surface components of the heterogeneous transfer layer. By virtue of the discontinuous, heterogeneous nature of the transfer layer, the subsequently applied protective coating may not form a coherent continuous layer and may, in fact, exhibit discontinuities.

To ensure effective protection, the protective coating medium may include a surfactant to facilitate uniform spreading of the coating medium over the transfer layer and penetration into the discontinuities in the transfer surface. Conventional surfactants may be employed, particularly a cationic surfactant, such as stearamidopropyldimethyl- -hydroxyethylammonium dihydrogen phosphate.

If desired, the protective coating medium may also contain a catalyst to promote cross-linking of the binder resin and/or additional cross-linkable resin present in the transfer layer. A suitable catalyst comprises p-toluene sulphonic acid.

The thickness of the applied protective coating should be such, after drying, as will provide the requisite degree of protection. In general, the protective coating desirably exhibits a dry coat thickness of at least 0.05 micron and preferably from 0.1 to 0.5 micron.

An assembly according to the invention may additionally comprise a lubricant layer on a surface remote from the substrate. Thus, the lubricant layer may be deposited directly onto the remote surface of the transfer layer, or, if a protective hydrophilic coating has been applied, a lubricant layer may be deposited onto the remote surface of the hydrophilic coating.

The lubricant layer may suitably comprise a wax, for example paraffin wax, particularly a paraffin wax having a clearing point of from 60 to 70°C. A wax lubricant layer of this kind improves the cold strength of the assembly, reduces frictional contact thereby reducing the risk of damage during handling and processing of the assembly, improves the transfer characteristics of the assembly and confers improved resistance to attack by chemical species - such as, hydroxyethylmethacrylate.

Each of the aforementioned layers - priming, protective and lubricant - contributes to the performance of the assembly and, according to a preferred embodiment of the invention a laser-imageable assembly therefore comprises a multi-layer structure as disclosed in EP-A-0 160 396 comprising

(1) a transparent substrate, and, applied in sequence outwardly from said substrate

(2) a primer layer,

(3) an energy absorbent transfer layer,

(4) a protective coating layer and,

(5) a lubricant coating layer,

each of the layers being as herein defined

An assembly according to the invention is suitable for use with a conventional laser - for example, of the solid type, such as a ruby crystal rod laser which emits a powerful and narrow beam of red light in ultra-short pulses, or of the gaseous type, such as a pulsed or continuous wave $CO_2$ laser, or a helium-neon laser in which the gas mixture is excited by a radio-frequency generator to produce a continuous energy beam. In general the laser beam employed should be selected to have a wave length short enough to deliver an adequate supply of energy to the target area. A preferred laser is therefore one which produces wave lengths in the infra-red region - such as a YAG (yttrium-aluminium-garnet) laser which has an effective wave length of about 1.06 microns, or an argon laser which has an effective wave length of from about 0.48 to about 0.52 micron.

An assembly according to the invention may be employed to produce an imaged printing plate by placing the coated surface of the assembly in intimate contact with a surface of a printing plate former, directing a laser beam image pattern through the transparent substrate of the assembly to transfer a portion of the coated surface corresponding to the image pattern from the substrate to the surface of the printing plate former precursor and, optionally, effecting cross-linking of the transferred portion.

An assembly according to the invention may be imaged by a laser beam to produce a negative transparent master of the image generated by the laser beam. The negative transparent master may be employed as a graphics intermediate in the production of an imaged photopolymer printing plate. Thus, an imaged photopolymer printing plate may be produced by directing a laser beam image pattern through the transparent substrate of an assembly to produce a negative transparent master comprising an assembly from which an image portion of the transfer layer has been displaced, placing the imaged master in contact with the photopolymerisable surface of a photopolymer printing plate former precursor, directing actinic radiation through the master to irradiate an image portion of the photopolymerisable surface, and processing the irradiated surface by known technique(s) to yield a photopolymer printing plate.

The invention is illustrated by reference to the following Examples.

EXAMPLE 1

This is a comparative Example not according to the invention.

A laser-imageable assembly was prepared as follows:

(a) Substrate

A biaxially oriented, uncoated, polyethylene terephthalate film of 75 microns thickness was employed as the transparent substrate.

(b) Priming Layer

One surface of the substrate was coated with a solution in acetone of p-chloro-m-cresol (3.75% weight/vol) and VINYLITE VAGH (0.75% weight/vol), VINYLITE VAGH is a copolymer of vinylchloride (90 wt%) and vinyl acetate (4 wt%) with 2.3 wt% hydroxyl content and of average molecular weight 23,000.

The primed substrate was then dried in a hot air oven maintained at a temperature of 80°C to leave a residual prime layer of approximately 0.2 micron thickness.

(c) Transfer layer (Homogeneous)

A dispersion of the following composition was applied to the primed substrate by a roller coating technique:

| DAG 580 | 200 ml |
|---|---|
| Cymel 300 | 0.3 g |
| Methylethylketone | 600 ml |
| p-toluene sulphonic acid | 0.17 g |

DAG 580 (Acheson Colloids) comprises about 18 parts by weight of graphite particles average particle size about 5 microns dispersed in about 4 parts by weight of ethylcellulose dissolved in about 77 parts by weight of ethanol.

Cymel 300 is a hexamethoxymethylmelamine cross-linking agent supplied by American Cyanamid Co.

The p-toluene sulphonic acid serves as a cross-linking catalyst.

The coated substrate was dried in a hot air oven at a relatively high temperature (110°C) to yield an assembly with a homogeneous cross-linked transfer layer. The assembly had an Optical Density of about 2.6 density units (Mc Beth Densitometer TD528/Wratten 18 A filter)

The assembly was imaged using a DAYTREX 760 laser plate maker supplied by Crosfield Electronics Ltd and comprising a transparent cylindrical drum of 1.9 metres circumference within which was located a YAG laser. The assembly was clamped with the transparent substrate in contact with the outer surface of the drum and with a paper receptor sheet against the outermost transfer layer. The laser was operated at a continuous power rating of 12 watts to produce a laser beam of wavelength 1.06 microns and spot size of 25 microns, while the drum rotated at a speed of 50 rps, i.e. a peripheral velocity of 95 ms$^{-1}$

The minimum optical density (Dmin) of the imaged portion of the resultant exposed assembly was 0.99 density units, and it was evident from visual inspection that a significant amount of graphite particles remaind attached to the substrate in the image area. This behaviour illustrates the difficulty of displacing a chemically-resistant transfer layer from a substrate to a receptor sheet.

EXAMPLE 2

The procedure of Example 1 was repeated save that drying of the transfer dispersion was effected at a relatively low temperature (65°C)to yield an assembly with a heterogeneous transfer layer, the assembly having a generally matt appearance and Optical Density of about 2.6 density units. When laser-imaged as described in Example 1, the imaged area of the assembly, although of speckled appearance - indicating incomplete transfer of the graphite layer, had a $D_{min}$ of 0.18 density units. A considerable improvement in transfer behaviour was therefore achieved by virtue of the heterogeneous nature of the transfer layer.

EXAMPLE 3

The procedure of Example 2 was repeated save that:

1) the dispersion applied to form a transfer layer did not contain a cross-linking catalyst,

2) in addition to being effected at a relatively low temperature (65°C), drying of the applied transfer dispersion was effected in the presence of a non-solvent (15 parts by weight of water in the transfer dispersion) to yield a heterogeneous transfer layer, and

3) a protective coating was applied by roller coating to the dry transfer layer from a dispersion comprising:

| Latamol | 0.4 g |
|---|---|
| p-toluene sulphonic acid | 0.17 g |
| Cationic SP | 0.02 g |
| Methanol | 65 ml |
| Acetone | 20 ml |
| Distilled water | 15 ml |

Latamol (supplied by BASF) is a condensate of formaldehyde with a sodium salt of naphthalene sulphonic acid.

Cationic SP (supplied by Cyanamid) is a quaternary ammonium surfactant.

The p-toluene sulphonic acid which serves as a cross-linking catalyst, was thus present in the protective coating rather than in the transfer layer.

The protective coating on the assembly was dried in an air oven at a temperature of 80°C to yield an assembly having a protective coat thickness of about 0.1 micron.

The assembly had an Optical Density of about 2.6 density units, and when laser-imaged as described in Example 1, the imaged area had a $D_{min}$ of about 0.18 density units. However, visual inspection revealed that the imaged area was not speckled and was relatively free from isolated specks of transfer coating. The imaged assembly was therefore visually attractive and more readily acceptable than that of Example 2.

EXAMPLE 4
———— —

The procedure of Example 3 was repeated save that, in addition, a lubricant coating was applied by roller to the protective layer from a solution comprising

|  | parts by weight |
| --- | --- |
| Paraffin wax (clearing point 65°C) | 1.0 |
| Trichloroethylene | 99.0 |

The lubricant-coated assembly was dried in an air oven at a temperature of 40°C to provide a lubricant coating of about 0.1 micron thickness.

The resultant assembly had an Optical Density and $D_{min}$ similar to the assembly of Example 3, but visual inspection established that the imaged area of an assembly exposed to a laser, as described in Example 1, comprised still fewer isolated spots of the transfer coating. In addition to the improved appearance, the assembly proved to be more durable and resistant to damage during haandling and processing by virtue of the wax lubricant top coating.

The laser-imaged assembly was employed as a graphic arts intermediate in the production of a photopolymer printing plate. When placed repeatedly in vacuum contact with the surface of a dry photopolymer plate former, of the 'Nyloprint' type supplied by BASF, and repeatedly exposed to UV radiation, there was no evidence of liftoff of the transfer layer from the assembly. The assembly was therefore of particular utility in the production of dry photopolymer printing plates.

**Claims**

1. A laser-imageable assembly comprising a transparent substrate having on a surface thereof an energy absorbent transfer layer comprising particles which absorb laser energy dispersed in a resin layer said resin layer being a heterogeneous, discontinuous layer the surface thereof remote from the substrate being cracked or crazed, said surface exhibiting a Gardner Gloss (45°) of less than 50% and the thickness of the resin layer being from 0.5 to 5.0μm.

2. An assembly according to claim 1 characterised in that the particles are graphite particles.

3. An assembly according to either of claims 1 and 2 characterised in that the assembly comprises an intermediate priming layer between the substrate and transfer layer.

4. An assembly according to any one of the preceding claims characterised in that the assembly comprises a hydrophilic protective coating remote from the substrate.

5. An assembly according to any one of the preceding claims characterised in that the assembly comprises a lubricant coating remote from the substrate.

6. An assembly according to any one of the preceding claims characterised in that the substrate is a polyester film.

7. An assembly according to claim 6 characterised in that the substrate is a biaxially oriented polyethylene terephthalate film.

8. A method of making a laser-imageable assembly comprising
   a) applying to a surface of a transparent substrate a coating medium comprising laser energy-absorbent particles and a resin binder dispersed in a volatile vehicle, and
   b) drying the applied coating medium, said drying being effected
   1) at a sufficiently low temperature, and optionally,
   2) in the presence of a non-solvent for the resin binder, to develop on the substrate a resin transfer layer, said resin layer being a heterogeneous, discontinuous layer, the surface thereof remote from the substrate being cracked or crazed, said surface exhibiting a Gardner Gloss (45°) of less than 50% and the thickness of the resin layer being from 0.5 to 5.0 $\mu$m.

9. A method of making an imaged printing plate characterised by placing the coated surface of an assembly according to any one of claims 1 to 7 or made according to the method of claim 8, in intimate contact with a surface of a printing plate former precursor and directing a laser beam image pattern through the transparent substrate of the assembly to transfer a portion of the coated surface corresponding to the image pattern from the substrate to the surface of the printing plate former, than, optionally, effecting cross-linking of the transferred portion.

10. A method of making an imaged photopolymer printing plate characterised by directing a laser beam image pattern through the transparent substrate of an assembly, according to any one of claims 1 to 7 or made according to the method of claim 8 to produce a negative transparent master comprising an assembly from which an image portion of the transfer layer has been displaced, placing the imaged master in contact with the photopolymerisable surface of a photopolymer printing plate former precursor, directing actinic radiation through the master to irradiate an image portion of the photopolymerisable surface, and processing the irradiated surface by known technique(s) to yield a photopolymer printing plate.

## Revendications

1. Assemblage pour la formation d'image par laser comprenant un substrat transparent dont une surface porte une couche de transfert absorbant l'énergie comprenant des particules qui absorbent l'énergie laser dispersée dans une couche de résine, cette couche de résine étant une couche hétérogène et discontinue dont la surface éloignée du substrat est craquelée ou fissurée, cette surface présentant un éclat Gardner (45°) inférieur à 50 % et l'épaisseur de la couche de résine étant de 0,5 à 5,0 microns.

2. Assemblage suivant la revendication 1, caractérisé en ce que les particules sont des particules de graphite.

3. Assemblage suivant l'une quelconque des revendications 1 et 2, caractérisé en ce que l'assemblage comprend une couche d'apprêt intermédiaire entre le substrat et la couche de transfert.

4. Assemblage suivant l'une quelconque des revendications précédentes, caractérisé en ce qu'il comprend un revêtement de protection hydrophile éloigné du substrat.

5. Assemblage suivant l'une quelconque des revendications précédentes, caractérisé en ce que l'assemblage comprend un revêtement de lubrifiant éloigné du substrat.

6. Assemblage suivant l'une quelconque des revendications précédentes, caractérisé en ce que le substrat est un film polyester.

7. Assemblage suivant la revendication 6, caractérisé en ce que le substrat est un film de téréphtalate de polyéthylène orienté biaxialement.

8. Procédé de fabrication d'un assemblage pour la formation d'image par laser comprenant :
   (a) l'application sur une surface d'un substrat transparent d'un milieu d'enduction comprenant des particules absorbant l'énergie laser et un liant de résine dispersé dans un véhicule volatil, et
   (b) le séchage du milieu d'enduction appliqué, ce séchage étant effectué
   (1) à une température suffisamment basse et éventuellement,
   (2) en présence d'un non-solvant pour le liant de résine, pour développer sur le substrat une couche de transfert de résine, cette couche de résine étant une couche hétérogène et discontinue dont la surface éloignée du substrat est craquelée ou fissurée, cette surface présentant un éclat Gardner (45°) inférieur à 50 % et l'épaisseur de la couche de résine étant de 0,5 à 5,0 microns.

9. Procédé de fabrication d'une plaque d'impression portant une image, caractérisé en ce que l'on place la surface enduite d'un assemblage suivant l'une quelconque des revendications 1 à 7, ou faite selon le procédé de la revendication 8, en contact étroit avec une surface d'un précurseur de matrice de plaque d'impression et que l'on dirige un faisceau laser selon un motif en forme d'image à travers le substrat transparent de l'assemblage pour transférer une partie de la surface enduite correspondant au motif en forme d'image du substrat à la surface de la matrice de plaque d'impression, puis éventuellement qu'on effectue une réticulation de la partie transférée.

10. Procédé de fabrication d'une plaque d'impression photopolymère portant une image, caractérisé en ce que l'on dirige un faisceau laser selon un motif en forme d'image à travers le substrat transparent d'un assemblage selon l'une quelconque des revendications 1 à 7 ou faite selon le procédé de la revendication 8, pour produire un original transparent négatif comprenant un assemblage dont une portion en forme d'image de la couche de transfert a été déplacée, qu'on place l'original portant une image en contact avec la surface photopolymérisable d'un précurseur de matrice de plaque d'impression photopolymère, qu'on dirige une radiation actinique à travers l'original pour irradier une portion en forme d'image de la surface photopolymérisable et que l'on traite la surface irradiée par une ou des techniques connues pour fournir une plaque d'impression photopolymère.

## Patentansprüche

1. Laser-abbildbarer Aufbau, **dadurch gekennzeichnet**, daß er einen transparenten Träger umfaßt, der auf seiner Oberfläche eine energieabsorbierende Transferschicht aufweist, die Partikel enthält, die Laserenergie absorbieren und in einer Harzschicht dispergiert sind, wobei die Harzschicht eine heterogene, diskontinuierliche Schicht ist, deren vom Träger entfernte Oberfläche rissig oder haarrissig ist, wobei die Oberfläche einen Gardner-Glanz (45°) von weniger als 50 % aufweist und die Dicke der Harzschicht von 0,5 bis 5,0 $\mu$m beträgt.

2. Aufbau nach Anspruch 1, **dadurch gekennzeichnet**, daß die Partikel Graphitpartikel sind.

3. Aufbau nach einem der Ansprüche 1 und 2, **dadurch gekennzeichnet**, daß der Aufbau eine intermediäre Grundierschicht zwischen dem Träger und der Transferschicht umfaßt.

4. Aufbau nach einem der vorhergehenden Ansprüche, **dadurch gekennzeichnet**, daß der Aufbau eine vom Träger entferne hydrophile Schutzbeschichtung umfaßt.

5. Aufbau nach einem der vorhergehenden Ansprüche, **dadurch gekennzeichnet**, daß der Aufbau eine vom Träger entfernte Schmiermittelbeschichtung umfaßt.

6. Aufbau nach einem der vorhergehenden Ansprüche, **dadurch gekennzeichnet**, daß der Träger ein Polyesterfilm ist.

7. Aufbau nach Anspuch 6, **dadurch gekennzeichnet**, daß der Träger ein biaxial ausgerichteter Polyethylen-Terephthalat-Film ist.

8. Verfahren zur Herstellung eines Laser-abbildbaren Aufbaus, **dadurch gekennzeichnet**, daß es folgende Schritte umfaßt:
a) Aufbringen eines Beschichtungsmediums auf die Oberfläche eines transparenten Trägers, das Laserenergie absorbierende Partikel und einen Harzbinder, der in einem flüchtigen Medium dispergiert ist, umfaßt, und
b) Trocknen des aufgebrachten Beschichtungsmediums, wobei das Trocknen durchgeführt wird:
1) bei einer ausreichend niedrigen Temperatur und wahlweise
2) in Gegenwart eines Nicht-Lösemittels für den Harzbinder, um auf dem Träger eine Harztransferschicht zu bilden, wobei die Harzschicht eine heterogene, diskontinuierliche Schicht ist, deren vom Träger entfernte Oberfläche rissig oder haarrissig ist, wobei die Oberfläche einen Gardner-Glanz (45°) von weniger als 50 % aufweist und die Dicke der Harzschicht von 0,5 bis 5,0 μm beträgt.

9. Verfahren zur Herstellung einer mit einem Bild versehenen Druckplatte, **dadurch gekennzeichnet**, daß die beschichtete Oberfläche eines Aufbaus nach einem der Ansprüche 1 bis 7 oder hergestellt nach dem Verfahren nach Anspruch 8, in engen Kontakt mit einer Oberfläche eines Vorläufers eines Druckplattenformers gebracht wird, und daß ein Laserstrahl-Bildmuster durch den transparenten Träger des Aufbaus gerichtet wird, um einen Teil der beschichteten Oberfläche, die dem Bildmuster entspricht, von dem Träger auf die Oberfläche des Druckplattenformers zu übertragen, worauf wahlweise eine Quervernetzung des übertragenen Teils durchgeführt wird.

10. Verfahren zur Herstellung einer mit einem Bild versehenen Fotopolymer-Druckplatte, **dadurch gekennzeichnet**, daß ein Laserstrahl-Bildmuster durch den transparenten Träger eines Aufbaus nach einem der Ansprüche 1 bis 7 oder hergestellt nach dem Verfahren nach Anspruch 8 gerichtet wird, um eine transparente Negativmatrize zu erzeugen, die einen Aufbau umfaßt, von dem ein Bildteil der Transferschicht verdrängt wurde, so daß die mit einem Bild versehene Matrize in Kontakt mit der fotopolymerisierbaren Oberfläche eines Vorläufers eines Fotopolymer-Druckplattenformers gebracht wird und actinische Strahlung durch die Matrize gerichtet wird, um einen Bildteil der fotopolymerisierbaren Oberfläche zu bestrahlen und Bearbeitung der bestrahlten Oberfläche durch bekannte Technik(en), um eine Fotopolymer-Druckplatte zu liefern.